# EUROPÄISCHE PATENTSCHRIFT

(11) **EP 4 469 257 B1**
(45) Veröffentlichungstag und Bekanntmachung des Hinweises auf die Patenterteilung: **20.08.2025**
(21) Anmeldenummer: 23701619.1
(22) Anmeldetag: 04.01.2023
(51) Int. Cl.: B29C 48/92, B29C 48/49, B29C 48/18, B29L 30/00

(54) **VORRICHTUNG UND COMPUTERIMPLEMENTIERTES VERFAHREN ZUR STEUERUNG EINER EXTRUSIONSANLAGE, EXTRUSIONSANLAGE UND COMPUTERLESBARES SPEICHERMEDIUM**
DEVICE AND COMPUTER-IMPLEMENTED METHOD FOR CONTROLLING AN EXTRUSION PLANT, EXTRUSION PLANT, AND COMPUTER-READABLE STORAGE MEDIUM
DISPOSITIF ET MÉTHODE MISE EN OEUVRE PAR ORDINATEUR POUR COMMANDER UNE INSTALLATION D'EXTRUSION, INSTALLATION D'EXTRUSION ET SUPPORT DE STOCKAGE LISIBLE PAR ORDINATEUR

(30) Priorität: 25.01.2022 DE 102022200817
(43) Veröffentlichungstag der Anmeldung: 04.12.2024
(73) Patentinhaber: Continental Reifen Deutschland GmbH, 30175 Hannover (DE)
(72) Erfinder: SCHRAMM, Oliver, 30175 Hannover (DE); KUNZE, Christian, 30175 Hannover (DE); KOLL, David, 30175 Hannover (DE)
(74) Vertreter: Continental Corporation
(86) Internationale Anmeldenummer: PCT/DE2023/200000
(87) Internationale Veröffentlichungsnummer: WO 2023/143675

(56) Entgegenhaltungen:
- EP-A1- 0 011 355
- EP-A2- 1 201 397
- US-A- 4 425 289

## Beschreibung

### Technisches Gebiet

Die vorliegende Erfindung betrifft allgemein eine Vorrichtung und ein computerimplementiertes Verfahren zur Steuerung einer Extrusionsanlage mit mindestens einem Extrusionskopf, eine Extrusionsanlage und ein computerlesbares Speichermedium.

### Stand der Technik

Extrusionsanlagen sind aus dem Stand der Technik bekannt. Sie werden beispielsweise zur Herstellung von Reifen für die Produktion von Extrudaten wie Halbzeugen, z.B. Seitenwänden, Laufflächen usw. eingesetzt. Insbesondere bei der Verbesserung der Qualität von Reifen spielen Extrusionsanlagen eine äußerst wichtige Rolle.

Die EP0011355A1 offenbart ein Extrusionssystem zur Herstellung von kontinuierlich extrudiertem Elastomer, wie beispielsweise Laufflächenmaterial für die Herstellung von Fahrzeugreifen.

Die US4425289A offenbart ein Verfahren zur Herstellung eines Extrudats, bei dem Online-Anpassungen an Größen- und Formabweichungen durch Variation der Temperaturbedingungen im Extruder und durch Variation der relativen Geschwindigkeiten entlang der Extrusionslinie vorgenommen werden.

Ferner offenbart die EP1201397A2 eine Vorrichtung zur Herstellung eines sehr dünnen Bandes aus unvulkanisiertem Gummi (G) mit einer Enddicke T0 im Bereich von 0,3 bis 1,5 mm umfasst.

Ein Reifen besteht aus mehreren Bereichen, wie Lauffläche, Seitenwand und Schulterstreifen. Darüber hinaus besteht jeder dieser Bereiche aus mehreren Gummisegmenten mit unterschiedlichen Eigenschaften, so dass der Reifen hinsichtlich Reifeneigenschaften wie niedrigem Rollwiderstand, hoher Laufleistung, gutem Bremsverhalten und geringer Geräuschabstrahlung optimiert werden kann. Wie gut die angestrebten Reifeneigenschaften erreicht werden, hängt maßgeblich davon ab, wie genau das Reifenprofil realisiert werden kann.

Es ist ein Verfahren bekannt, bei dem eine Extrusionsanlage verwendet wird, um mehrere Gummibereiche als ein Bauteil herzustellen. Mit Hilfe einer Extrusionsanlage können je nach der Anzahl der in einen Extrusionskopf mündenden Extruder beliebig viele Extrudate aus unterschiedlichen Materialmischungen in einem Arbeitsgang zu einem gemeinsamen Extrudat, etwa einer Laufflächenkomponente zusammengefügt werden. Beispielsweise können Materialmischungen wie Naturkautschuk, synthetischer Kautschuk, elektrisch leitende Segmente wie Silica-Mischungen verwendet werden.

Mittels eines Trichters wird Material einem Einzugsbereich einem Extruder mit einer Schnecke zugeführt. Während das Material durch die Schnecke in Richtung eines Extrusionskopfs transportiert wird, wird das Material plastifiziert und mit Heiz- /Kühlelementen temperiert. Das warme Material wird durch Fließkanäle im Extrusionskopf aus einer formgebenden Öffnung (einer Schablone) auf eine Fördervorrichtung herausgepresst. Dort unterliegt das Material zum Teil extremen Materialumlenkungen vom z.B. runden Durchmesser aus der Schneckenzone in eine z.B. rechteckige flache Profilform. Die geformte Masse wird als Extrudat bezeichnet.

Durch eine gleichmäßige Zuführung und eine spezielle Schneckengeometrie wird ein hoher und gleichmäßiger Füllgrad und somit ein konstanter pulsationsfreier Ausstoß bei einer hohen Durchsatzleistung erreicht. Die Schneckendurchmesser variieren dabei von etwa 45-350 Millimeter mit maximalen Ausstoßleistungen von 120-7.000 kg/h.

Die gefertigten Extrudate können mehrere unterschiedliche Komponenten aufweisen. Dabei ist die Form der einzelnen Komponenten des Extrudats (mit unterschiedlichen Mischungen) sowie des gesamten Extrudats abhängig von Prozess-, Material- und Maschinenparametern. Maschinen- und Prozessparameter können z.B. Extrusionsgeschwindigkeit, Materialmischung der Komponenten, Druck im Fließkanal des Extrusionskopfs, Temperatur im Zylinder um die Schnecke und im Fließkanal des Extrusionskopfs, Drehzahl der Schnecke, Geometrie des Fließkanals im Extrusionskopf und weitere Parameter sein. Um die Qualitäts- und Leistungsanforderungen bzgl. der Geometrie des Extrudats zu erfüllen, ist es notwendig, die verschiedenen beeinflussenden Parameter möglichst genau zu steuern. Es ist bekannt, dass die Steuerung der Extrusionsanlage manuell und/oder automatisch erfolgen kann.

Bei bisher bekannten automatischen Steuerungssystemen wird während des laufenden Betriebs die Extrusionsdrehzahl oder die Geschwindigkeit des Transports des Extrudats mittels einer Fördervorrichtung auf der Grundlage gemessener geometrischer Daten eines warmen oder eines kalten Extrusionsprofils variiert. Nachteilig an diesem Verfahren ist jedoch, dass das Extrudatprofil erst 5-12 m oder sogar bis zu 100 m nach einer Ausgangsseite des Extrusionskopfs im warmen bzw. kalten Zustand gemessen wird.

### Probleme, die durch die Erfindung gelöst werden

Weicht das Profil des kalten Extrudats von einem spezifischen Profil ab, erfolgt eine Anpassung der Parameter somit erst zeitverzögert. Daher kann über einen Prozesszeitraum, der von der Geschwindigkeit der Erkennung und Reaktion auf falsche Prozessparameter abhängt, ein "nicht spezifikationsgerechtes Extrudat" hergestellt werden, das die gestellten Qualitäts- und Leistungsanforderungen nicht oder nur unzureichend erfüllt. Dieses Extrudat kann für die weitere Verarbeitung nicht verwendet werden und wird vom übrigen Extrudat abgetrennt und entsorgt. Zudem wird insbesondere beim anschließend notwendigen Hochfahren der Vorrichtung eine Menge an nicht konformem Material hergestellt, das ebenfalls nach Durchlaufen der Vorrichtung ausgesondert werden muss.

Ausgehend von diesem Stand der Technik ist es eine Aufgabe der vorliegenden Erfindung, die genannten Nachteile zu überwinden. Insbesondere ist es Aufgabe der Erfindung, die Qualität und die Effizienz des Extrusionsprozesses zu verbessern. Es ist weiter insbesondere Aufgabe der Erfindung, den Ausschuss bei der Extrusion zu verringern.

### Mittel zum Lösen des Problems

Diese Aufgabe wird gelöst durch eine Vorrichtung nach Anspruch 1, ein computerimplementiertes Verfahren zur Steuerung einer Extrusionsanlage nach Anspruch 10, eine Extrusionsanlage nach Anspruch 13 und ein computerlesbares Speichermedium nach Anspruch 14.

Insbesondere wird die Aufgabe durch eine Vorrichtung zur Steuerung einer Extrusionsanlage mit mindestens einem Extrusionskopf zur Formung mindestens eines Extrudats gelöst, die Folgendes aufweist:
- eine Profilbestimmungseinheit, die dazu ausgebildet ist, ein warmes Extrudatprofil mindestens eines Extrudats, insbesondere zumindest im Wesentlichen kontaktlos, zu bestimmen, wobei das warme Extrudatprofil geometrische Daten des Extrudats in einem warmen Zustand angibt,
- eine erste Kaltprofil-Modellierungseinheit, die dazu ausgebildet ist, basierend auf dem warmen Extrudatprofil und initialen Prozessparametern ein Extrudatmodell zu parametrieren, welches ein erstes kaltes Extrudatprofil des Extrudats in einem abgekühlten Zustand bestimmt,
- eine Vergleichseinheit, die dazu ausgebildet ist, eine erste Abweichung zwischen dem bestimmten ersten kalten Extrudatprofil und einem spezifischen Extrudatprofil zu bestimmen,
- eine Parameterbestimmungseinheit, die dazu ausgebildet ist, unter Verwendung der ersten Abweichung Prozessparameter zu optimieren und veränderte Prozessparameter zu bestimmen, derart, dass eine Abweichung von einem produzierten kalten Extrudatprofil und dem spezifischen Extrudatprofil klein wird,
- eine Auswahleinheit, die dazu ausgebildet ist, die veränderten Prozessparameter als Eingabe für die Ansteuerungseinheit auszuwählen, wenn die Abweichung kleiner gleich einem Schwellwert ist, und
- eine Ansteuerungseinheit, die dazu ausgebildet ist, die Extrusionsanlage mit den veränderten Prozessparametern zu steuern, insbesondere um ein zweites warmes Extrudat zu produzieren.

Durch die erfindungsgemäße Vorrichtung kann eine verbesserte Steuerung der Extrusionsanlage erfolgen und der Ausschuss wird reduziert. Insbesondere wird ermöglicht, dass die Verwendung ungeeigneter Prozessparameter schnell erkannt und beendet wird. Somit wird der produzierte Ausschuss minimiert.

Die einzelnen Einheiten können miteinander in kommunikativer Verbindung stehen. Eine kommunikative Verbindung der Einheiten kann zum Beispiel über eine EtherCAT-Verbindung, Profibus, Profinet oder OPC hergestellt werden. Hierbei kann eine kabellose Verbindung zwischen den Einheiten bevorzugt sein. Alternativ kann eine kabelgebundene Verbindung zwischen den Einheiten möglich sein. Insbesondere kann eine lösbare oder nicht-lösbare Kabelverbindung erreicht werden.

Die Extrusionsanlage kann einen Trichter aufweisen, der dazu ausgebildet ist, Material aufzunehmen, das über eine Schnecke entlang eines Zylinders transportiert werden kann. Materialien können beispielsweise Naturkautschuk, synthetischer Kautschuk, elektrisch leitende Segmente mit hohem Rußanteil, Silica-Mischungen, Füllstoffe, Kunststoffe und/oder weitere Materialien sein. Während des Transports kann das Material über Heizelemente am Zylinder, der Schnecke und dem Extrusionskopf erwärmt werden, sodass es sich plastifiziert und temperiert werden kann. Das plastifizierte Material kann durch Fließkanäle im Extrusionskopf aus einer formgebenden Öffnung des Extrusionskopfs als Extrudat auf eine Fördervorrichtung herausgepresst werden. Die Fördervorrichtung kann beispielsweise ein Förderband, eine Rollenbahn, ein Roboter oder jede andere zum Transport des Extrudats geeignete Vorrichtung sein. Unmittelbar nach der Formung des Extrudats ist das Extrudat in einem warmen Zustand und weist ein für den warmen Zustand charakteristisches Extrudatprofil auf.

Die Profilbestimmungseinheit kann dazu ausgebildet ist, ein warmes Extrudatprofil mindestens eines Extrudats zu bestimmen, wobei das warme Extrudatprofil geometrische Daten des Extrudats in einem warmen Zustand angeben kann. Geometrische Daten eines Extrudatprofils, z.B. eines warmen und/oder kalten Extrudatprofils, können Daten zu einer Gesamthöhe, einer Gesamtbreite, einer Schulterhöhe, einer Schulterbreite, einer Gesamtquerschnittsfläche, mindestens einer Teilquerschnittsfläche und/oder einer Teilschichtdicke über mindestens eine Teilschicht des Extrudats umfassen, wenn das Extrudat aus mehreren Teilschichten aus mehreren Mischungskomponenten besteht. Die Profilbestimmungseinheit kann eine, zwei oder mehrere Vorrichtungen umfassen, die dazu angeordnet sein können, das warme und/oder das kalte Extrudatprofil des mindestens einen Extrudats insbesondere kontaktlos bestimmen. Zum Zeitpunkt der Profilbestimmung kann sich das Extrudat in einem warmen Zustand befinden. In diesem Zustand ist das Extrudat noch leicht formbar. Durch eine zumindest im Wesentlichen kontaktlose Profilbestimmung kann vermieden werden, dass das Extrudat durch die Profilbestimmungseinheit nachteilig verformt wird, d.h. es kann eine Profilbestimmung des Extrudats ohne Beeinträchtigung des Extrudats erfolgen. Dazu kann die Profilbestimmungseinheit visuelle Sensoren, insbesondere Lasersensoren, Ultraschallsensoren, Kameras oder andere Sensoren zur kontaktlosen Profilbestimmung aufweisen. Insbesondere kann die Profilbestimmungseinheit ein Profilometer sein. Zur Bestimmung der Teilschichtdicke über mindestens eine Teilschicht des Extrudats kann insbesondere eine Schichtdickenbestimmungseinheit vorgesehen sein. Die Profilbestimmungseinheit kann somit auch aus einem Profilometer und einer Schichtdickenbestimmungseinheit gebildet sein.

Die Informationen über das warme Extrudatprofil können an eine erste Kaltprofil-Modellierungseinheit weitergeleitet werden. Die erste Kaltprofil-Modellierungseinheit ist dazu ausgebildet, basierend auf dem warmen Extrudatprofil und initialen Prozessparametern ein Extrudatmodell zu parametrieren, welches ein erstes kaltes Extrudatprofil des Extrudats in einem abgekühlten Zustand bestimmt. Grundsätzlich kann die Extrusionsanlage dazu ausgebildet sein, kontinuierlich ein Extrudat herzustellen. Insofern kann ein erstes und/oder ein zweites Extrudat ein Bereich des kontinuierlich hergestellten Extrudats sein, das mit denselben Prozessparametern hergestellt wurde. Ein erstes Extrudat unterscheidet sich somit von einem zweiten Extrudat insbesondere durch die Prozessparameter, die zur Herstellung verwendet wurden. Initiale Prozessparameter können Prozessparameter der Extrusionsanlage angeben, die während des Herstellungsprozesses des warmen Extrudats vorliegen und das warme Extrudatprofil beeinflussen. Initiale Prozessparameter können somit auch als Rezeptparameter bezeichnet werden, da sie durch ein Rezept zur Herstellung des Extrudats vorgegeben sein können. Neben den Prozessparametern kann das Extrudatprofil von der Geometrie des Extrusionskopfs und einer formgebenden Schablone, der Materialmischung und dem Extrusionsverfahren (ziehende Extrusion oder relaxierende Extrusion, englisch pulled extrusion und relaxed extrusion) beeinflusst werden. Die Parametrierung des Extrudatmodells kann mittels künstlicher Intelligenz, insbesondere neuronalen Netzen oder Gradient Boosting durchgeführt werden. Insofern können für die Parametrierung des Extrudatmodells zusätzlich Informationen über die Geometrie des Extrusionskopfs und der formgebenden Schablone, der Materialmischung und das Extrusionsverfahren verwendet werden. Das erstes kalte Extrudatprofil des Extrudats in einem abgekühlten Zustand kann sich von dem warmen Extrudatprofil des Extrudats anhand der geometrischen Daten des Extrudatprofils unterscheiden. Das Extrudat geht während der Herstellung von einem warmen Zustand in einen kalten Zustand über, wobei in dem jeweiligen Zustand unterschiedliche Extrudatprofile vorliegen.

Die Informationen über das erste kalte Extrudatprofil des Extrudats in einem abgekühlten Zustand werden einer Vergleichseinheit zur Verfügung gestellt. Die Vergleichseinheit ist dazu ausgebildet, eine erste Abweichung zwischen dem ersten kalten Extrudatprofil und einem spezifischen Extrudatprofil zu bestimmen.

Das spezifische Extrudatprofil kann ein kaltes Extrudatprofil eines Extrudats in einem kalten Zustand angeben, das möglichst genau mit der Extrusionsanlage hergestellt werden soll. Das heißt, dass das spezifische Extrudatprofil geometrische Sollwerte des Extrudats vorgeben kann. Dem spezifischen Extrudatprofil können festgelegte Informationen über die Geometrie eines kalten Extrudatprofils eines Extrudats zugeordnet werden. Die Abweichung kann sich insbesondere auf eine Abweichung einer, mehrerer oder aller geometrischer Daten des ersten kalten Extrudatprofils und des spezifischen Extrudatprofils beziehen.

Die Bestimmung der Abweichung kann ein Vergleichen des ersten kalten Extrudatprofils und des spezifischen Extrudatprofils umfassen, insbesondere der geometrischen Daten des ersten kalten Extrudatprofils und des spezifischen Extrudatprofils.

Bei dem Vergleich von Extrudatprofilen kann ganz allgemein jede einzelne geometrische Größe eines ersten Extrudatprofils und eines zweiten Extrudatprofils jeweils miteinander verglichen werden. Die Vergleichsergebnisse stellen je eine Abweichung zwischen dem ersten Extrudatprofil und dem zweiten Extrudatprofil bzgl. einer geometrischen Größe dar. Ein Extrudatprofil kann in einer Ausführungsform als ein Vektor bereitgestellt werden, wobei die Vergleichseinheit dazu ausgebildet sein kann, die Vektordifferenz der Extrudatprofile als erste Abweichung zu bestimmen. Der Vektor kann beispielsweise in jeder Dimension eine Information über die in Geometrie des entsprechenden Extrudats angeben, wie vorstehend beschrieben. Bei der Bestimmung der Abweichung kann weiter insbesondere ein gewichtetes Vergleichen des ersten Extrudatprofils und des zweiten Extrudatprofils durchgeführt werden, wobei eine oder mehrere geometrische Größen des Extrudatprofils eine höhere Gewichtung erhalten als eine oder mehrere andere geometrische Größen des Extrudatprofils. Insofern können Anwendungsspezifische Metriken definiert werden. Diese Art des Vergleichs kann für jedweden Vergleich von Extrudatprofilen im Rahmen dieser Offenbarung verwendet werden, z.B. zwischen dem ersten kalten Extrudatprofil und dem spezifischen Extrudatprofil. Die Anwendung des gewichteten Vergleichs von geometrischen Größen hat den Vorteil, dass eine oder mehrere geometrische Größen stärker in der Gesamtabweichung berücksichtigt werden können. Insofern ist es möglich, geometrischen Größen stärker zu gewichten, bei denen eine Abweichung des gefertigten Extrudats vom spezifischen Extrudat kritischer ist, d.h. beispielsweise mit einer aufwändigen Nachbearbeitung verbunden ist.

Das Ergebnis der ersten Abweichung zwischen dem ersten kalten Extrudatprofil und einem spezifischen Extrudatprofil kann an eine Parameterbestimmungseinheit weitergeleitet werden.

Die Parameterbestimmungseinheit ist dazu ausgebildet, unter Verwendung der ersten Abweichung Prozessparameter zu optimieren und veränderte Prozessparameter zu bestimmen, derart, dass eine Abweichung von einem produzierten kalten Extrudatprofil und dem spezifischen Extrudatprofil klein wird.

Prozessparameter können eine Drehzahl der Schnecke, ein Druck im Fließkanal des Extrusionskopfs, eine Temperatur im Zylinder um die Schnecke und im Fließkanal des Extrusionskopfs und/oder weitere Parameter sein. Die Parameterbestimmungseinheit kann insbesondere einen oder mehrere Prozessparameter optimieren. Eine Abweichung von dem produzierten kalten Extrudatprofil und dem spezifischen Extrudatprofil kann als klein bezeichnet werden, wenn die Abweichung kleiner als ein festgelegter Schwellwert ist. Dabei wird insbesondere jede einzelne erste Abweichung zwischen dem ersten kalten Extrudatprofil und einem spezifischen Extrudatprofil bzgl. einer geometrischen Größe mit dem Schwellwert verglichen. Eine Abweichung von dem produzierten kalten Extrudatprofil und dem spezifischen Extrudatprofil kann daher als klein bezeichnet werden, wenn jede der ersten Abweichungen jeweils kleiner als der festgelegte Schwellwert ist. Der Schwellwert kann insbesondere aus einem oder mehreren unterschiedlichen Teilschwellwerten bestehen, wobei ein Teilschwellwert die Abweichung einer oder mehrerer geometrischer Größen von dem produzierten kalten Extrudatprofil und einer oder mehrerer geometrischer Größen dem spezifischen Extrudatprofil angeben kann. Ein oder mehrere Teilschwellwerte können zu einem gemeinsamen Schwellwert zusammengefasst werden. Alternativ kann ein einzelner Teilschwellwert zur Bestimmung der Prozessparamater verwendet werden. Dadurch kann der Schwellwert je nach Bedarf individuell festgelegt werden. Der Schwellwert kann somit ebenfalls als ein Vektor repräsentiert sein, wobei jede Vektordimension einen für ein geometrisches Datum spezifischen Grenzwert angeben kann. Es ist ferner denkbar, dass die Parameterbestimmungseinheit dazu ausgebildet ist, den Betrag des Schwellwerts zu bestimmen, um diesen Betrag mit einem Schwellwert zu vergleichen.

Die Parameterbestimmungseinheit kann dazu ausgebildet sein, das Optimieren durch ein Grandientenverfahren zu implementieren, wobei die Abweichung minimiert wird. Somit können auf effiziente Art und Weise optimale Prozessparameter bestimmt werden.

Die Vorrichtung weist ferner eine Auswahleinheit auf, die dazu ausgebildet ist, die veränderten Prozessparameter als Eingabe für die Ansteuerungseinheit auszuwählen, insbesondere die optimierten Prozessparameter, wenn die Abweichung kleiner gleich einem Schwellwert ist. Die Auswahleinheit kann in kommunikativer Verbindung mit der Parameterbestimmungseinheit stehen, von der sie die Information über die veränderten Prozessparameter empfangen kann und diese als Eingabe an die Ansteuerungseinheit weiterleiten kann.

Die Ansteuerungseinheit ist dazu ausgebildet, basierend auf den Informationen über die veränderten Prozessparameter die Extrusionsanlage mit den veränderten Prozessparametern zu steuern. Die Ansteuerungseinheit kann insbesondere eine oder mehrere Vorrichtungen der Extrusionsanlage mit den veränderten Prozessparametern steuern. Insbesondere kann die Ansteuerungseinheit die Drehzahl der Schnecke und die Temperatur im Zylinder um die Schnecke unmittelbar über Vorrichtungen der Extrusionsanlage steuern. Ferner kann die Ansteuerungseinheit den Druck im Fließkanal des Extrusionskopfs, die Temperatur des Fließkanals des Extrusionskopfs und/oder weitere Parameter über Vorrichtungen der Extrusionsanlage mittelbar steuern, z.B. über die Drehzahl der Schnecke.

In einer Ausführungsform kann die Parameterbestimmungseinheit ferner Folgendes aufweisen:
- eine Warmprofil-Modellierungseinheit, die dazu ausgebildet sein kann, basierend auf den veränderten Prozessparametern und/oder dem warmen Extrudatprofil ein simuliertes warmes Extrudatprofil zu bestimmen, und
- eine zweite Kaltprofil-Modellierungseinheit, die dazu ausgebildet sein kann, basierend auf dem simulierten warmen Extrudatprofil und/oder den veränderten Prozessparametern ein zweites simuliertes kaltes Extrudatprofil zu bestimmen, wobei die Vergleichseinheit ferner dazu ausgebildet sein kann, eine zweite Abweichung zwischen dem bestimmten zweiten kalten simulierten Extrudatprofil und dem spezifischen Extrudatprofil zu bestimmen.

Die Warmprofil-Modellierungseinheit kann mit der Parameterbestimmungseinheit in kommunikativer Verbindung stehen, und dazu ausgebildet sein, Informationen über die veränderten ersten Prozessparameter zu empfangen. Die Warmprofil-Modellierungseinheit kann mit der Profilbestimmungseinheit in kommunikativer Verbindung stehen, und dazu ausgebildet sein, Informationen über das warme Extrudatprofil des mindestens einen Extrudats zu erhalten. Basierend auf den veränderten Prozessparametern und dem warmen Extrudatprofil kann die Warmprofil-Modellierungseinheit ein simuliertes warmes Extrudatprofil bestimmen. Das Bestimmen des simulierten warmen Extrudatprofils kann eine Parametrierung des Extrudatmodells einschließen. Die Parametrierung des Extrudatmodells kann grundsätzlich mittels künstlicher Intelligenz, insbesondere neuronalen Netzen und/oder Gradient Boosting durchgeführt werden. Insofern können für die Parametrierung des Extrudatmodells, zur Bestimmung eines warmen Extrudatprofils und/oder eines kalten Extrudatprofils, zusätzlich Informationen über die Geometrie des Extrusionskopfs und einer formgebenden Schablone, der Materialmischung und das Extrusionsverfahren verwendet werden.

Die Warmprofil-Modellierungseinheit kann dazu ausgebildet sein, an eine zweite Kaltprofil-Modellierungseinheit Informationen über das simulierte warme Extrudatprofil weiterzuleiten. Die zweite Kaltprofil-Modellierungseinheit kann dazu ausgebildet sein, von der Parameterbestimmungseinheit Informationen über die veränderten Prozessparameter zu empfangen. Basierend auf dem simulierten warmen Extrudatprofil und den veränderten Prozessparametern kann die zweite Kaltprofil-Modellierungseinheit dazu ausgebildet sein, ein zweites simuliertes Kaltprofil zu bestimmen. Das Bestimmen des zweiten simulierten kalten Extrudatprofils kann eine Parametrierung des Extrudatmodells einschließen. Die Extrusionsanlage kann so gesteuert werden, dass das zu dem spezifischen Kaltprofil gehörende Warmprofil erzeugt wird, d.h. ein Extrudat mit einem warmen Extrudatprofil, welches nach dem Auskühlen das spezifische Kaltprofil aufweist.

Die zweite Kaltprofil-Modellierungseinheit kann ferner dazu ausgebildet sein, Informationen über das zweite kalte Extrudatprofil des Extrudats an die Vergleichseinheit zu übermitteln. Die Vergleichseinheit kann ferner dazu ausgebildet sein, eine zweite Abweichung zwischen dem bestimmten zweiten kalten Extrudatprofil und dem spezifischen Extrudatprofil zu bestimmen.

Dabei können in einer Ausführungsform die Warmprofil-Modellierungseinheit und die zweite Kaltprofil-Modellierungseinheit dazu ausgebildet sein, abwechselnd ein warmes Extrudatprofil zu bestimmen und anschließend ein kaltes Extrudatprofil. Somit kann die Vergleichseinheit dazu ausgebildet sein, nach jedem Durchlauf eine Abweichung des zweiten kalten Extrudatprofils von dem spezifischen Extrudatprofil zu bestimmen. Unter Verwendung einer Optimierungsmethode, wie zum Beispiel einer Gradientenmethode, kann die Abweichung durch mehrfaches bestimmen von warmen Extrudatprofil und kaltem Extrudatprofil minimiert bzw. optimiert werden.

Durch die Verwendung der zweiten Kaltprofil-Modellierungseinheit und/oder der Warmprofil-Modellierungseinheit kann die Optimierung der Prozessparameter somit weiter verbessert werden. Insbesondere kann die Güte der Optimierung erhöht werden, indem die zweite Abweichung zwischen dem bestimmten zweiten kalten Extrudatprofil und dem spezifischen Extrudatprofil bestimmt wird. Dadurch kann die Qualität des hergestellten Extrudats verbessert werden, indem weniger geringere Abweichungen von spezifischen Extrudateigenschaften erreicht werden. Schließlich kann die Menge an Nacharbeit an einem nicht konformem Extrudat und die Materialverschwendung reduziert werden, was zu einer höheren Effizienz der Extrusionsanlage und verringertem Zeitaufwand bei der Herstellung des spezifikationsgerechten Extrudats führt.

In einer Ausführungsform kann die Vorrichtung eine Gewichtsbestimmungseinheit zur Bestimmung eines warmen Extrudatgewichts des zumindest einen Extrudats aufweisen, insbesondere an einer Ausgangsseite des Extrusionskopfs.

Die Gewichtsbestimmungseinheit kann insbesondere weniger als 40 m, oder weniger als 30 m, oder weniger als 20 m, oder kleiner gleich 10 m, oder weiter insbesondere 7-10 m an einer Ausgangsseite des Extrusionskopfs angeordnet sein. Die Gewichtsbestimmungseinheit kann das warme Extrudatgewicht des zumindest einen Extrudats als längenbezogenes Gewicht, insbesondere als Metergewicht, bestimmen. Die Gewichtsbestimmungseinheit kann eine Waage oder jede andere zur Bestimmung des Extrudatgewichts geeignete Vorrichtung sein.

Durch die Gewichtsbestimmungseinheit können der ersten Kaltprofil-Modellierungseinheit zusätzlich Informationen über das Extrudatgewicht zur Verfügung gestellt werden und dadurch die Genauigkeit des Extrudatmodells erhöht werden.

In einer Ausführungsform kann der Schwellwert einer Abweichung von weniger als 5%, weniger als 3%, weniger als 2%, weniger als 1%, bevorzugt weniger als 0,5% des zumindest ersten simulierten kalten Extrudatprofils und des spezifischen Extrudatprofils entsprechen. Der Schwellwert kann sich auf auch jede Dimension eines Vektors beziehen, sodass für jede Dimension der Abweichung der Schwellwert eingehalten werden muss.

Die Bestimmung der Abweichung kann ein Vergleichen des ersten kalten Extrudatprofils und des spezifischen Extrudatprofils umfassen, insbesondere der geometrischen Daten des ersten kalten Extrudatprofils und des spezifischen Extrudatprofils.

Die Abweichung kann sich insbesondere auf eine Abweichung einer, mehrerer oder aller geometrischer Daten des ersten kalten Extrudatprofils und des spezifischen Extrudatprofils beziehen.

In einer Ausführungsform kann die Profilbestimmungseinheit dazu ausgebildet sein, ein zweites warmes Extrudatprofil für ein zweites warmes Extrudat zu bestimmen und mit dem simulierten warmen Extrudatprofil zu vergleichen, wobei die zweite Kaltprofil-Modellierungseinheit dazu ausgebildet sein kann, das zweite warme Extrudatprofil zu verwenden, wenn eine Abweichung zwischen dem zweiten warmen Extrudatprofil und dem simulierten warmen Extrudatprofil größer als der Schwellwert ist, wobei insbesondere die Vergleichseinheit zur Bestimmung der Abweichung ausgebildet sein kann.

Dies hat den Vorteil, dass bei einer ungenauen Vorhersage des zweiten warmen Extrudatprofils durch das simulierte warme Extrudatprofil der Prozess gestoppt werden kann, sodass dann das tatsächlich gemessene zweite warme Extrudatprofil verwendet wird, um das kalte Extrudatprofil zu bestimmen bzw. die Abweichung vom simulierten Warmprofil und dem realen Warmprofil als Steuergröße für die Steuereinheit verwendet wird. Dem zweiten warmen Extrudatprofil und dem simulierten warmen Extrudatprofil liegen dieselben Prozessparameter zu Grunde, sodass diese bei einem optimalen Extrudatmodell identisch sein müssten. Somit kann weiter der Ausschuss der Anlage reduziert werden.

Die Auswahleinheit kann dazu ausgebildet sein, mit der Parameterbestimmungseinheit in kommunikativer Verbindung zu stehen, um die Information über die veränderten Prozessparameter zu empfangen. Die Auswahleinheit kann dazu ausgebildet sein, die veränderten Prozessparameter auszuwählen, wenn die zweite Abweichung kleiner gleich dem Schwellwert ist, und die initialen Prozessparameter auswählen, wenn die zweite Abweichung größer als der Schwellwert ist. Die Auswahleinheit kann dazu ausgebildet sein, die veränderten Prozessparameter und/oder die initialen Prozessparameter als Eingabe an die Ansteuerungseinheit weiterzuleiten.

Die erste Kaltprofil-Modellierungseinheit, die zweite Kaltprofil-Modellierungseinheit und/oder die Warmprofil-Modellierungseinheit können als voneinander getrennte Modellierungseinheiten ausgebildet sein. In einer Ausführungsform kann die erste Kaltprofil-Modellierungseinheit, die zweite Kaltprofil-Modellierungseinheit und/oder die Warmprofil-Modellierungseinheit als eine Modellierungseinheit ausgebildet sein. Die erste Kaltprofil-Modellierungseinheit, die zweite Kaltprofil-Modellierungseinheit und/oder die Warmprofil-Modellierungseinheit können aus den gleichen Komponenten aufgebaut sein und ähnliche Funktionen ausführen und/oder Eingaben verwenden. Bei den Modellierungseinheiten kann es sich um Software handeln, die durch einen Prozessor ausgeführt wird. Es ist aber auch eine verteilte Ausführung denkbar, bei der jede Modellierungseinheit durch einen anderen Prozessor ausgeführt wird. Es ist weiter denkbar, dass die Komponenten der Vorrichtung als Hardware ausgeführt sind, z.B. durch eine Implementierung von Teilen der Vorrichtung auf einem FPGA oder ASIC.

Das Extrudat in einem warmen Zustand kann sich von einem Extrudat im kalten Zustand unterscheiden. Das Extrudat in einem warmen Zustand kann eine höhere Temperatur als das Extrudat in einem kalten Zustand aufweisen. Ferner kann das Extrudat in einem warmen Zustand näher an der Ausgangsseite des Extrusionskopfs angeordnet sein als das Extrudat in einem kalten Zustand. In einer Ausführungsform kann das Extrudat in einem warmen Zustand eine Temperatur von mehr als 60°C, oder mehr als 55°C, oder mehr als 50°C aufweisen und/oder auf einer Fördervorrichtung in einem Abstand von weniger als 40 m, oder weniger als 30 m, oder weniger als 20 m, oder kleiner gleich 10 m an der Ausgangsseite des Extrusionskopfs angeordnet sein und/oder das Extrudat in einem kalten Zustand eine Temperatur von kleiner gleich 50°C, oder weniger als 45°C, oder weniger als 40°C aufweisen und/oder auf einer Fördervorrichtung in einem Abstand von mehr als 80 m, oder mehr als 50 m, oder mehr als 30 m, oder mehr als 10 m an der Ausgangsseite des Extrusionskopfs angeordnet sein. Der Übergang des Extrudats vom warmen Zustand in den kalten Zustand hängt von dem Profil, insbesondere der Dicke des gefertigten Extrudats und der Wärmeleitfähigkeit des Materials ab. Ein Extrudat großer Dicke weist ein größeres Volumen auf, in dem Wärme gespeichert ist als ein Extrudat kleiner Dicke. Es dauert somit länger, bis das Extrudat großer Dicke eine Temperatur aufweist, die im kalten Bereich liegt, als das Extrudat kleiner Dicke. Das Extrudat großer Dicke kann von der Fördervorrichtung daher bis zum Erreichen des kalten Zustands über eine weitere Strecke transportiert werden als das Extrudat kleiner Dicke und kann demnach in einem größeren Abstand an einer Ausgangsseite des Extrusionskopfs angeordnet sein. Das Extrudat kleiner Dicke kann eine Extrudatdicke von 1-3 mm aufweisen. Das Extrudat großer Dicke kann eine Extrudatdicke von 5-30 mm aufweisen. Bei einer Extrudatdicke von 1-3 mm kann der kalte Zustand bei einem Transport in einem Abstand von kleiner 10 m von dem Extusionskopf erreicht sein. Bei einer Extrudatdicke von 5-30 mm kann der kalte Zustand bei einem Transport in einem Abstand von größer 80 m von dem Extusionskopf erreicht sein.

In einer Ausführungsform kann das Bestimmen des kalten Extrudatprofils und/oder das Bestimmen des warmen Extrudatprofils mittels künstlicher Intelligenz, insbesondere einem neuronalen Netz, weiter insbesondere einem LSTM-basierten System, und/oder Gradient Boosting, oder mit einem analytischen oder empirischen Modell durchgeführt werden. Das heißt, dass die verschiedenen Modellierungseinheiten bzw. das Extrudatmodell selbst als ein KI-System ausgebildet sein können. Zum Beispiel kann die Kaltprofil-Modellierungseinheit ein Neuronales Netz oder ein Gradient-Boosting-basiertes Verfahren aufweisen bzw. implementieren sein. Die Warmprofil-Modellierungseinheiten können jeweils ein zeitreihenbasiertes KI-System implementieren, z.B. ein Gradient-Boosting-System oder Neuronales Netz. Dabei kann bei einem neuronalen Netz zum Beispiel ein Long-Short-Term-Memory (LSTM)-basiertes System eingesetzt werden. Die KI-Systeme können mit Trainingsdaten trainiert sein, die im normalen Herstellungsprozess gemessen werden. Dazu können an üblichen Produktionsstraßen Sensoren angeordnet sein, die ein Warmprofil und ein entsprechendes Kaltprofil vermessen. Diese Daten können dann als Trainingsdaten verwendet werden.

Durch KI-Systeme können Zusammenhänge zwischen dem warmem Extrudatprofil, dem simulierten kalten Extrudatprofil und Prozessparametern hergestellt und beurteilt werden und basierend auf der Beurteilung eine Optimierung von Prozessparametern durchgeführt werden.

In einer Ausführungsform kann die Vorrichtung einen Speicher aufweisen, der dazu ausgebildet sein kann, warme und kalte Extrudatprofile von produzierten Extrudaten sowie Prozessparameter zu speichern, insbesondere in vordefinierten Intervallen, wobei die Kaltprofil- und/oder die Warmprofil-Modellierungseinheiten dazu ausgebildet sein können, das Extrudatmodell unter Verwendung der gespeicherten Extrudatprofile zu trainieren.

Neben einem initialen Sammeln von Trainingsdaten können auch während des normalen Betriebs der Extrusionsanlage weitere Trainingsdaten gesammelt werden. Mit jedem Prozessdurchlauf werden Informationen zum Trainieren des Modells erhoben, sodass mit steigender Zahl an Prozessdurchläufen mehr Informationen zur Verfügung stehen. Durch eine stetig steigende Anzahl an Extrudatprofilen kann das Modell stetig trainiert werden und die Optimierung der Prozessparameter weiter verbessert werden.

Das Empfangen und Verwenden von Informationen in vordefinierten Intervallen beschreibt einen iterativen Vorgang. Beispielsweise werden Informationen über einen Zeitraum von einer Woche, einem Monat oder einem Jahr gesammelt und dann den Kaltprofilmodellierungseinheiten und/oder der Warmprofilmodellierungseinheit zur Verfügung gestellt.

Somit kann mittels der hierin beschriebenen Vorrichtung eine verbesserte Steuerung der Extrusionsanlage erfolgen und der Ausschuss reduziert werden.

Die eingangs genannte Aufgabe wird weiterhin insbesondere durch ein computerimplementiertes Verfahren zur Steuerung einer Extrusionsanlage gelöst, das folgende Schritte aufweist:
a) Bestimmen eines warmen Extrudatprofils von mindestens einem Extrudat mittels einer Profilbestimmungseinheit, wobei das warme Extrudatprofil geometrische Daten des Extrudats in einem warmen Zustand angibt,
b) Parametrieren eines Extrudatmodells mittels einer ersten Kaltprofil-Modellierungseinheit basierend auf dem warmen Extrudatprofil und initialen Prozessparametern, wobei das Extrudatmodell, ein erstes kaltes Extrudatprofil des Extrudats in einem abgekühlten Zustand bestimmt,
c) Bestimmen einer ersten Abweichung zwischen dem bestimmten ersten kalten Extrudatprofil und einem spezifischen Extrudatprofil mittels einer Vergleichseinheit,
d) Optimieren von Prozessparametern und Bestimmen von veränderten Prozessparametern unter Verwendung der ersten Abweichung mittels einer Parameterbestimmungseinheit, derart, dass eine Abweichung von einem produzierten kalten Extrudatprofil und dem spezifischen Extrudatprofil klein wird,
e) Auswählen der veränderten Prozessparameter als Eingabe für eine Ansteuerungseinheit der Extrusionsanlage, wenn die Abweichung kleiner gleich einem Schwellwert ist, mittels einer Auswahleinheit und
f) Steuern der Extrusionsanlage mit den veränderten Prozessparametern mittels einer Ansteuerungseinheit.

Die hierin beschriebene Vorrichtung kann insbesondere unter Verwendung eines hierin beschriebenen Verfahrens zur Steuerung einer Extrusionsanlage verwendet werden bzw. das Verfahren kann durch die beschriebene Vorrichtung umgesetzt werden. Insofern sind die hinsichtlich der Vorrichtung beschriebenen Abwandlungen und Weiterbildungen auch hinsichtlich des Verfahrens anwendbar.

In einer Ausführungsform kann die Parameterbestimmungseinheit dazu ausgebildet sein, folgende Schritte auszuführen:
- Bestimmen eines simulierten warmen Extrudatprofils basierend auf den veränderten Prozessparametern und/oder dem warmen Extrudatprofil mittels einer Warmprofil-Modellierungseinheit, und
- Bestimmen eines zweiten simulierten Extrudatprofils basierend auf dem simulierten warmen Extrudatprofil und den veränderten Prozessparametern mittels einer zweiten Kaltprofil-Modellierungseinheit, wobei das Bestimmen ein Bestimmen einer zweiten Abweichung zwischen dem zweiten simulierten kalten Extrudatprofil und dem spezifischen Extrudatprofil umfasst.

In einer Ausführungsform kann das Verfahren ein Bestimmen eines warmen Extrudatgewichts des zumindest einen Extrudats umfassen, insbesondere durch eine Gewichtsbestimmungseinheit der vorstehend beschriebenen Vorrichtung.

Das Bestimmen der Abweichung kann ein Vergleichen des ersten kalten Extrudatprofils und des spezifischen Extrudatprofils umfassen, insbesondere der geometrischen Daten des ersten kalten Extrudatprofils und des spezifischen Extrudatprofils.

In einer Ausführungsform kann das Verfahren die folgenden Schritte aufweisen:
- Bestimmen eines zweiten warmem Extrudatprofils für ein zweites warmes Extrudat;
- Vergleichen des zweiten warmen Extrudaptofils mit dem simulierten warmen Extrudatprofil, insbesondere durch die Vergleichseinheit,
- Verwenden des zweiten warmen Extrudatprofils bei der Bestimmung des kalten Extrudatprofils, wenn eine Abweichung zwischen dem zweiten warmen Extrudatprofil und dem simulierten warmen Extrudatprofil größer als der Schwellwert ist.

Das Verfahren kann in einer Ausführungsform ein Weiterleiten der veränderten und/oder der initialen Prozessparameter an die Ansteuerungseinheit umfassen.

In einer Ausführungsform kann das Bestimmen des kalten Extrudatprofils und/oder die Simulation des warmen Extrudatprofils mittels künstlicher Intelligenz, insbesondere einem neuronalen Netz oder durch Gradient Boosting durchgeführt werden. Dadurch können Zusammenhänge zwischen dem warmem Extrudatprofil, dem simulierten kalten Extrudatprofil und Prozessparametern hergestellt und beurteilt werden und basierend auf der Beurteilung eine Optimierung von Prozessparametern durchgeführt werden.

Somit kann das mittels des hierin beschriebenen Verfahrens eine verbesserte Steuerung der Extrusionsanlage bereitgestellt werden. Es ergeben sich ähnliche Vorteile, wie diese bereits in Verbindung mit der Vorrichtung erläutert wurden.

Die Aufgabe wird ferner insbesondere gelöst durch eine Extrusionsanlage, insbesondere Multiplex-Extrusionsanlage Folgendes aufweisend:
- eine Vorrichtung zur Steuerung einer Extrusionsanlage, wie sie vorstehend beschrieben ist;
- mindestens einen Extrusionskopf;
- mindestens eine Schnecke;
- mindestens einen Schneckenantrieb;
- mindestens einen Zylinder; und
- mindestens einen Befülltrichter; und/oder
- mindestens eine Materialtransporteinheit; und/oder
- mindestens eine Kühleinheit.

Es ergeben sich ähnliche oder identische Vorteile, wie sie bereits im Zusammenhang mit der vorstehend beschriebenen Vorrichtung beschrieben worden sind.

Die Aufgabe wird ferner insbesondere gelöst durch ein computerlesbares Speichermedium, welches Instruktionen enthält, die mindestens einen Prozessor dazu veranlassen, ein Verfahren wie es vorstehend beschrieben ist, zu implementieren, wenn die Instruktionen durch den mindestens einen Prozessor ausgeführt werden.

Es ergeben sich ähnliche oder identische Vorteile, wie sie bereits im Zusammenhang mit der vorstehend beschriebenen Vorrichtung beschrieben worden sind.

Weitere Ausführungsformen ergeben sich aus den Unteransprüchen.

### Kurze Beschreibung der Zeichnungen

Im Folgenden wird die Erfindung anhand von Ausführungsbeispielen näher erläutert.

Dabei zeigen:
- Figur 1:: eine schematische Seitenansicht einer Extrusionsanlage mit einem Extrusionskopf;
- Figur 2:: eine schematische Seitenansicht einer Extrusionsanlage mit drei Extrusionsköpfen;
- Figur 3:: eine schematische Schnittansicht eines hergestellten Extrudats aus drei Schichten;
- Figur 4:: eine schematische Darstellung einer Vorrichtung zur Steuerung einer Extrusionsanlage mit einem Extrusionskopf;
- Figur 5:: ein Flussdiagramm eines Verfahrens zur Steuerung einer Extrusionsanlage.

### Beschreibung der Ausführungsform/en

Nachstehend werden Ausführungsbeispiele der Erfindung erläutert. In den Zeichnungen bezeichnen gleiche Bezugszeichen die gleichen oder ähnliche Merkmale der jeweiligen Ausführungsformen.

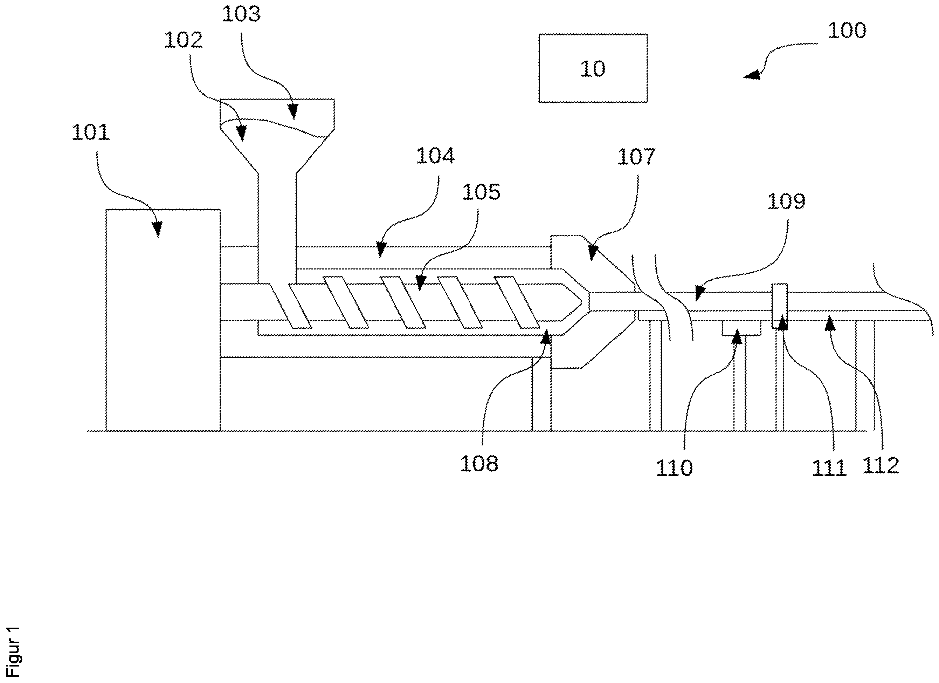

Die Figur 1 zeigt eine vereinfachte schematische Seitenansicht einer erfindungsgemäßen Vorrichtung 10 zur Steuerung einer Extrusionsanlage 100 mit mindestens einem Extrusionskopf zur Formung mindestens eines Extrudats. Die Extrusionsanlage 100 umfasst im Wesentlichen die nachfolgenden Komponenten: Schneckenantrieb 101; Schnecke 105; Befülltrichter 102; Zylinder 104; Extrusionskopf 107; Gewichtsbestimmungseinheit 110; Profilbestimmungseinheit 111 und Fördervorrichtung 112.

Der Extrusionsanlage 100 wird über einen Trichter 102 Material 103 zugeführt, das über eine Schnecke 105 entlang eines Zylinders 104 in Richtung eines Extrusionskopfs 107 transportiert wird. Während des Transports wird das Material 103 über Heizbeschichtungen, die am Zylinder 104 angebracht sind, erwärmt, sodass es sich plastifiziert. Das plastifizierte Material 108 wird durch Fließkanäle im Extrusionskopf aus einer formgebenden Öffnung des Extrusionskopfs 107 als Extrudat 109 auf ein Förderband 112 herausgepresst.

Die Gewichtsbestimmungseinheit 110 ist dazu vorgesehen, ein Extrudatgewicht des zumindest einen warmen Extrudats als längenbezogenes Gewicht, insbesondere als Metergewicht, zu bestimmen. Die Gewichtsbestimmungseinheit 110 ist an einer Ausgangsseite des Extrusionskopfs in einem Abstand von 75 cm von der Ausgangsseite des Extrusionskopfs entfernt angeordnet. Als Gewichtsbestimmungseinheit ist eine Waage vorgesehen.

Nach der Formung des Extrudats 109 ist das Extrudat in einem warmen Zustand und weist ein für den warmen Zustand charakteristisches Extrudatprofil auf. Die Profilbestimmungseinheit 111 ist dazu vorgesehen, ein warmes Extrudatprofil des Extrudats 109 zu bestimmen, wobei das warme Extrudatprofil geometrische Daten des Extrudats in einem warmen Zustand angibt. Die Gewichtsbestimmungseinheit 110 ist zwischen dem Extrusionskopf 107 und der Profilbestimmungseinheit 111 angeordnet.

Die Profilbestimmungseinheit 111 bestimmt das warme Extrudatprofil des mindestens einen Extrudats 109 kontaktlos über Kameras, die oberhalb und seitlich von dem Extrudat angeordnet sind.

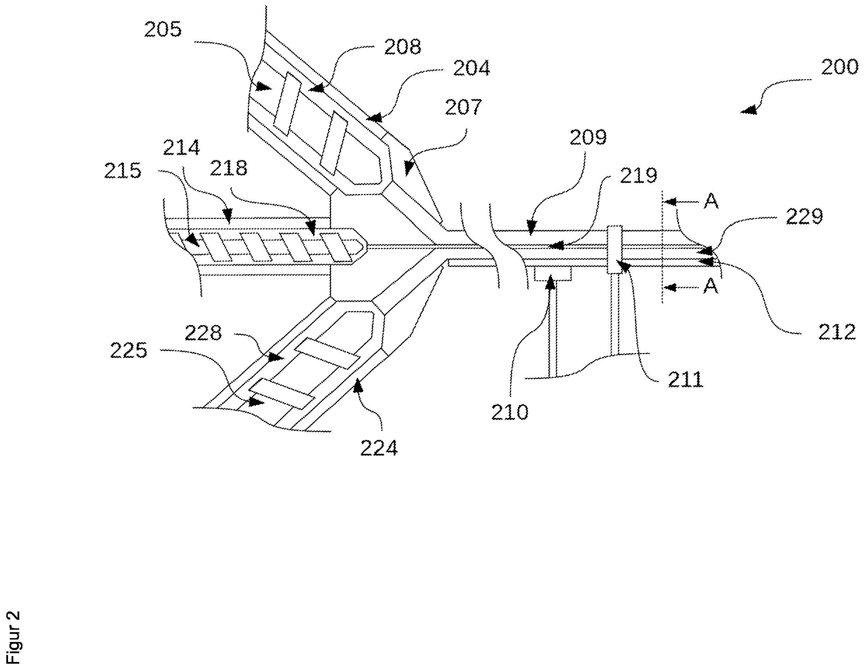

Die Figur 2 veranschaulicht eine schematische Seitenansicht einer erfindungsgemäßen Extrusionsanlage 200, die gegenüber der Extrusionsanlage 100 aus Fig. 1 dahingehend abgeändert ist, dass anstelle von einem Extrudat 109 drei Extrudate 209, 219, 229 erzeugt werden. Es handelt sich somit um eine Multi-Extrusionsanlage. Den einzelnen Zylindern 204, 214, 224 und darin angeordneten Schnecken 205, 215, 225 wird unterschiedliches Material über je einen Trichter (nicht dargestellt) zugeführt. Die Materialien werden über die Schnecken 205, 215, 225 entlang der Zylinder 204, 214, 224 in Richtung eines gemeinsamen Extrusionskopfs 207 transportiert. Während des Transports wird das Material über Heizbeschichtungen, die an den Zylindern 204, 214, 224 angebracht sind, erwärmt, sodass es sich zu plastifiziertem Material 208, 218, 228 plastifiziert. Das plastifizierte Material 208, 218, 228 wird durch Fließkanäle im Extrusionskopf 207 aus einer formgebenden Öffnung, d.h. über eine Schablone, des Extrusionskopfs 207 als gemeinsames Extrudat 239, das aus Teil-Extrudaten 209, 219 und 229 gebildet wird, auf eine Fördervorrichtung 212 herausgepresst. Die Fördervorrichtung 212 ist als ein Förderband ausgebildet und transportiert das Extrudat 239 weiter.

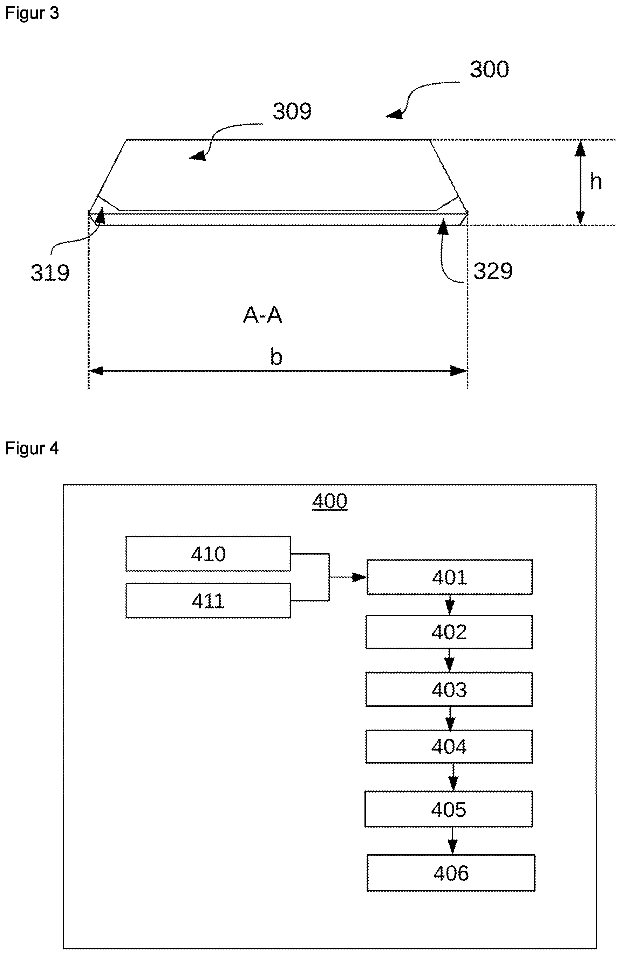

In Figur 3 ist ein gemeinsames Extrudat 300 in einer Schnittansicht A-A dargestellt, bestehend aus den Teil-Extrudaten 309, 319 und 329. Die Teil-Extrudate 309, 319 und 329 sind in gestapelter Weise angeordnet, um das Extrudat 300 zu bilden. Das Extrudat 300 weist ein Teil-Extrudat 309 auf, das auf dem Teil-Extrudat 319 gebildet wird. Das Teil-Extrudat 319 wiederum wird auf dem Teil-Extrudat 329 gebildet. Je nach Bedarf können die einzelnen Teil-Extrudate 309, 319, 329 verschiedene Dicken und Anordnungen zueinander aufweisen. Es ist beispielsweise denkbar, dass das Teil-Extrudat 319 auf dem Teil-Extrudat 309 gebildet wird, das wiederum auf dem Teil-Extrudat 329 gebildet wird. Weiterhin kann es sein, dass das Teil-Extrudat 309 im Vergleich zu den Teil-Extrudaten 319 und 329 die geringste Dicke aufweist. Ferner ist es denkbar, dass die Teil-Extrudate eines gemeinsamen Extrudats nebeneinander, in nicht gestapelter Weise angeordnet sein können. Die Anordnung der Teilextrudate kann in jeder beliebigen Weise erfolgen.

Figur 4 zeigt eine schematische Darstellung einer erfindungsgemäßen Vorrichtung 400 zur Steuerung einer Extrusionsanlage mit einem Extrusionskopf. Die Vorrichtung 400 weist Folgende Elemente auf, wobei die Vorrichtung 400 z.B. mit der Extrusionsanlage 100 der Figur 1 oder 2 verwendet werden kann und der entsprechenden Vorrichtung 10 entspricht: eine Gewichtsbestimmungseinheit 410, eine Profilbestimmungseinheit 411, eine erste Kaltprofil-Modellierungseinheit 402, eine Vergleichseinheit 403, eine Parameterbestimmungseinheit 404, eine Auswahleinheit 405 und eine Ansteuerungseinheit 406. Die einzelnen Einheiten sind miteinander über eine EtherCAT-Verbindung kommunikativ verbunden. Ferner sind in der vorliegenden Ausführungsform die erste Kaltprofil-Modellierungseinheit, die zweite Kaltprofil-Modellierungseinheit und die Warmprofil-Modellierungseinheit als eine Modellierungseinheit ausgebildet.

Aus einem Extrusionskopf wird ein Extrudat 409 herausgepresst und auf dem Förderband weiter transportiert. Die Gewichtsbestimmungseinheit 410 ist dazu vorgesehen, ein Extrudatgewicht des zumindest einen warmen Extrudats als Metergewicht zu bestimmen. Weiterhin ist eine Profilbestimmungseinheit 411 dazu vorgesehen, ein warmes Extrudatprofil des Extrudats 409 zu bestimmen, wobei das warme Extrudatprofil geometrische Daten des Extrudats in einem warmen Zustand angibt. Die Profilbestimmungseinheit 411 bestimmt in dem gezeigten Ausführungsbeispiel die Gesamthöhe und die Gesamtbreite des Extrudats.

Die erste Kaltprofil-Modellierungseinheit 402 steht in kommunikativer Verbindung mit der Gewichtsbestimmungseinheit 410 und/oder der Profilbestimmungseinheit 411, um von der Gewichtsbestimmungseinheit 410 und/oder der Profilbestimmungseinheit 411 Information über das Gewicht und/oder das Profil des Extrudats zu erhalten. Weiterhin erhält die erste Kaltprofil-Modellierungseinheit 402 Informationen über initiale Prozessparameter. Die initialen Prozessparameter können aus einer Speichereinrichtung ausgelesen werden, die z.B. über eine Netzwerkschnittstelle mit der Vorrichtung kommunikativ verbunden ist.

Die erste Kaltprofil-Modellierungseinheit 402 ist dazu vorgesehen, basierend auf dem warmen Extrudatprofil und den initialen Prozessparametern ein Extrudatmodell zu parametrieren, welches ein erstes kaltes Extrudatprofil des Extrudats in einem abgekühlten Zustand bestimmt. In dem gezeigten Ausführungsbeispiel ist das Extrudatmodell als ein Grandient-Boosting basiertes Verfahren implementiert.

Das Extrudat in einem warmen Zustand weist in der vorliegenden Ausführungsform eine Temperatur von 55°C auf. Ferner ist das Extrudat in einem warmen Zustand in einem Abstand von 1 m von der Ausgangsseite des Extrusionskopfs entfernt auf dem Förderband vermessen worden.

Das Extrudat in einem kalten Zustand weist in der vorliegenden Ausführungsform eine Temperatur von 30°C auf. Ferner ist das Extrudat in einem kalten Zustand in einem Abstand von 20 m von der Ausgangsseite des Extrusionskopfs entfernt auf dem Förderband vermessen bzw. angeordnet.

Die erste Kaltprofil-Modellierungseinheit 402 steht in kommunikativer Verbindung mit der Vergleichseinheit 403, um das erste kalte Extrudatprofil des Extrudats in einem abgekühlten Zustand an die Vergleichseinheit 403 weiterzuleiten. Die Vergleichseinheit 403 ist dazu ausgebildet, eine erste Abweichung zwischen dem ersten kalten Extrudatprofil und einem spezifischen Extrudatprofil zu bestimmen. Dazu werden zunächst das erste kalte Extrudatprofil und das spezifische Extrudatprofil verglichen, insbesondere die Gesamthöhe und Gesamtbreite des ersten kalten Extrudatprofils und des spezifischen Extrudatprofils. Diese Größen werden einzeln miteinander verglichen, sodass alles geometrischen Größen innerhalb einer vorgegebenen Spezifikation liegen. In der vorliegenden Ausführungsform beträgt die erste Abweichung 1,5% für die Gesamthöhe und die Gesamtbreite.

Das Ergebnis der ersten Abweichung zwischen dem ersten kalten Extrudatprofil und einem spezifischen Extrudatprofil wird an eine Parameterbestimmungseinheit 404 weitergeleitet, die in kommunikativer Verbindung mit der Vergleichseinheit 403 steht.

Die Parameterbestimmungseinheit 404 ist dazu ausgebildet, unter Verwendung der ersten Abweichung Prozessparameter zu optimieren und veränderte Prozessparameter zu bestimmen, derart, dass eine Abweichung von einem produzierten kalten Extrudatprofil und dem spezifischen Extrudatprofil klein wird.

In der vorliegenden Ausführungsform optimiert die Parameterbestimmungseinheit 404 bei einer nicht kleinen Abweichung, insbesondere bei einer Abweichung größer als ein festgelegter Schwellwert, eine Drehzahl der Schnecke. In der vorliegenden Ausführungsform liegt der Schwellwert bei einer Abweichung von weniger als 2% des ersten simulierten kalten Extrudatprofils und des spezifischen Extrudatprofils.

Ferner weist die Parameterbestimmungseinheit eine Warmprofil-Modellierungseinheit 407 auf, die dazu ausgebildet ist, basierend auf den veränderten ersten Prozessparametern, d.h. in der vorliegenden Ausführungsform der veränderten Drehzahl der Schnecke, und/oder dem warmen Extrudatprofil ein simuliertes warmes Extrudatprofil zu bestimmen. Dazu parametriert die Warmprofil-Modellierungseinheit 407 das Extrudatmodell mit den veränderten Prozessparametern.

Die Warmprofil-Modellierungseinheit 407 leitet Informationen über das simulierte warme Extrudatprofil an eine zweite Kaltprofil-Modellierungseinheit 408 weiter. Basierend auf dem simulierten warmen Extrudatprofil und den veränderten Prozessparametern bestimmt die zweite Kaltprofil-Modellierungseinheit 408 ein zweites simuliertes kaltes Extrudatprofil.

Die zweite Kaltprofil-Modellierungseinheit 408 leitet Informationen über das zweite kalte Extrudatprofil des Extrudats an die Vergleichseinheit 403. Die Vergleichseinheit 403 bestimmt eine zweite Abweichung zwischen dem bestimmten zweiten kalten Extrudatprofil und dem spezifischen Extrudatprofil. Im vorliegenden Fall werden die Gesamthöhe und Gesamtbreite des zweiten kalten Extrudatprofils und des spezifischen Extrudatprofils miteinander verglichen. In der vorliegenden Ausführungsform beträgt die zweite Abweichung 1%.

Das Ergebnis der zweiten Abweichung wird an die Auswahleinheit 405 weitergeleitet, die in kommunikativer Verbindung mit der Vergleichseinheit 403 steht. Die Auswahleinheit 405 wählt entsprechend der zweiten Abweichung von 1% die veränderten Prozessparameter als Eingabe für die Ansteuerungseinheit 406 aus, da die zweite Abweichung kleiner gleich dem Schwellwert von 1% ist.

Die Auswahleinheit 405 leitet diese Information über die veränderten Prozessparameter als Eingabe an die Ansteuerungseinheit 406 weiter. Die Ansteuerungseinheit 406 steuert entsprechend den veränderten Prozessparametern die Drehzahl der Schnecke.

Würde die zweite Abweichung höher als der Schwellwert, hier 1%, sein, so könnten die Warmprofil-Modellierungseinheit und die Kaltprofil-Modellierungseinheit weitere Warm- und Kaltprofile bestimmen, bis die Parameterbestimmungseinheit veränderte Prozessparameter bestimmt hat, die die Abweichung unter den Schwellwert fallen lässt.

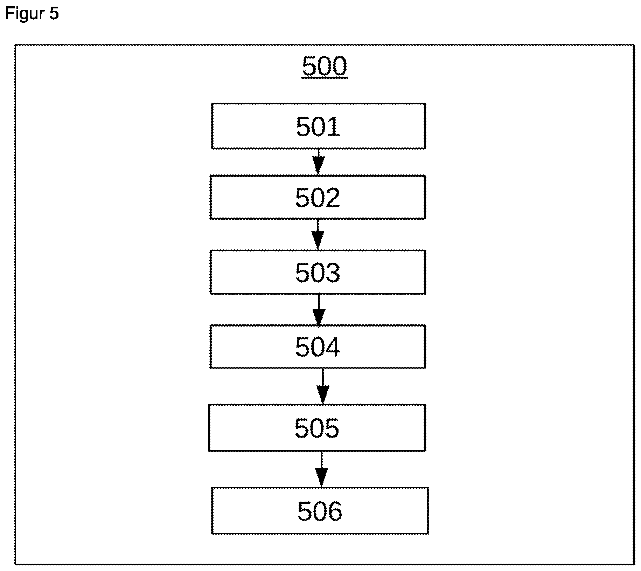

Gemäß weiteren Ausführungsformen, die mit anderen hierin beschriebenen Ausführungsformen kombiniert werden können, kann die hierin beschriebene Vorrichtung insbesondere unter Verwendung eines hierin beschriebenen Verfahrens zur Steuerung einer Extrusionsanlage verwendet werden. Figur 5 zeigt ein Ablaufdiagramm eines erfindungsgemäßen Verfahrens 400 zur Steuerung einer Extrusionsanlage.

Das Verfahren umfasst in einem Schritt 501 ein Bestimmen eines warmen Extrudatprofils von mindestens einem Extrudat mittels einer Profilbestimmungseinheit, wobei das warme Extrudatprofil geometrische Daten des Extrudats in einem warmen Zustand angibt. Ferner umfasst das Verfahren 500 in einem zweiten Schritt 502 ein Parametrieren eines Extrudatmodells mittels einer ersten Kaltprofil-Modellierungseinheit basierend auf dem warmen Extrudatprofil und initialen Prozessparametern, wobei das Extrudatmodell, ein erstes kaltes Extrudatprofil des Extrudats in einem abgekühlten Zustand bestimmt. Des Weiteren umfasst das Verfahren in einem dritten Schritt 503 ein Bestimmen einer ersten Abweichung zwischen dem bestimmten ersten kalten Extrudatprofil und einem spezifischen Extrudatprofil mittels einer Vergleichseinheit. Ein vierter Schritt 504 des Verfahrens 500 umfasst ein Optimieren von Prozessparametern und Bestimmen von veränderten Prozessparametern unter Verwendung der ersten Abweichung mittels einer Parameterbestimmungseinheit, derart, dass eine Abweichung von einem produzierten kalten Extrudatprofil und dem spezifischen Extrudatprofil klein wird. Des Weiteren umfasst das Verfahren in einem fünften Schritt 505 ein Auswählen der veränderten Prozessparameter als Eingabe für eine Ansteuerungseinheit einer der Extrusionsanlage, wenn die Abweichung kleiner gleich einem Schwellwert ist, mittels einer Auswahleinheit. Ein sechster Schritt 506 des Verfahrens 500 umfasst ein Steuern der Extrusionsanlage mit den veränderten Prozessparametern mittels der Ansteuerungseinheit.

### Bezugszeichenliste

- 100: Extrusionsanlage mit einem Extrusionskopf
- 10: Vorrichtung zur Steuerung einer Extrusionsanlage
- 101: Schneckenantrieb
- 102: Befülltrichter
- 103: Extrusionsmaterial
- 104: Zylinder
- 105: Schnecke
- 107: Extrusionskopf
- 108: Plastifiziertes Material
- 109: Extrudat
- 110: Gewichtsbestimmungseinheit
- 111: Profilbestimmungseinheit
- 112: Fördervorrichtung

- 200: Extrusionsanlage mit drei Extrusionsköpfen
- 204/214/224: Zylinder
- 205/215/225: Schnecke
- 207: Extrusionskopf
- 208/218/228: Plastifiziertes Material
- 209/219/229: Teil-Extrudat
- 239: Gemeinsames Extrudat
- 210: Gewichtsbestimmungseinheit
- 211: Profilbestimmungseinheit
- 212: Fördervorrichtung

- 300: Extrudatprofil, das mittels der Extrusionsanlage (200) hergestellt wurde
- 309/319/329: Extrudat
- h: Gesamthöhe
- b: Gesamtbreite
- 400: Vorrichtung zur Steuerung einer Extrusionsanlage
- 401: Profilbestimmungseinheit
- 402: erste Kaltprofil-Modellierungseinheit
- 403: Vergleichseinheit
- 404: Parameterbestimmungseinheit
- 405: Auswahleinheit
- 406: Ansteuerungseinheit
- 407: Warmprofil-Modellierungseinheit
- 408: zweite Kaltprofil-Modellierungseinheit
- 410: Gewichtsbestimmungseinheit
- 411: Profilbestimmungseinheit

- 500: Verfahren zur Steuerung einer Extrusionsanlage
- 501: Bestimmen eines warmen Extrudatprofils von mindestens einem Extrudat
- 502: Parametrieren eines Extrudatmodells
- 503: Bestimmen einer ersten Abweichung zwischen dem bestimmten ersten kalten Extrudatprofil und einem spezifischen Extrudatprofil
- 504: Optimieren von Prozessparametern und Bestimmen von veränderten Prozessparametern
- 505: Auswählen der veränderten Prozessparameter als Eingabe für eine Ansteuerungseinheit einer der Extrusionsanlage
- 506: Steuern der Extrusionsanlage mit den veränderten Prozessparametern

## Patentansprüche

1. Vorrichtung (10) zur Steuerung einer Extrusionsanlage (100, 200, 300) mit mindestens einem Extrusionskopf (107) zur Formung mindestens eines Extrudats (109),
Folgendes aufweisend:
- eine Profilbestimmungseinheit, die dazu ausgebildet ist, ein warmes Extrudatprofil mindestens eines Extrudats (109, 209), insbesondere kontaktlos, zu bestimmen, wobei das warme Extrudatprofil geometrische Daten des Extrudats (109, 209) in einem warmen Zustand angibt,
- eine erste Kaltprofil-Modellierungseinheit (402), die dazu ausgebildet ist, basierend auf dem warmen Extrudatprofil und initialen Prozessparametern ein Extrudatmodell zu parametrieren, welches ein erstes kaltes Extrudatprofil des Extrudats (109, 209) in einem abgekühlten Zustand bestimmt,
- eine Vergleichseinheit, die dazu ausgebildet ist, eine erste Abweichung zwischen dem bestimmten ersten kalten Extrudatprofil und einem spezifischen Extrudatprofil zu bestimmen,
- eine Parameterbestimmungseinheit, die dazu ausgebildet ist, unter Verwendung der ersten Abweichung Prozessparameter zu optimieren und veränderte Prozessparameter zu bestimmen, derart, dass eine Abweichung von einem produzierten kalten Extrudatprofil und dem spezifischen Extrudatprofil klein wird,
- eine Auswahleinheit, die dazu ausgebildet ist, die veränderten Prozessparameter als Eingabe für die Ansteuerungseinheit auszuwählen, wenn die Abweichung kleiner gleich einem Schwellwert ist, und
- eine Ansteuerungseinheit, die dazu ausgebildet ist, die Extrusionsanlage (100, 200, 300) mit den veränderten Prozessparametern zu steuern, insbesondere um ein zweites warmes Extrudat (109, 209) zu produzieren.

2. Vorrichtung (10) nach Anspruch 1,
**dadurch gekennzeichnet, dass**
die Parameterbestimmungseinheit Folgendes aufweist:
- eine Warmprofil-Modellierungseinheit, die dazu ausgebildet ist, basierend auf den veränderten Prozessparametern und/oder dem warmen Extrudatprofil ein simuliertes warmes Extrudatprofil zu bestimmen, und
- eine zweite Kaltprofil-Modellierungseinheit (408), die dazu ausgebildet ist, basierend auf dem simulierten warmen Extrudatprofil und den veränderten Prozessparametern ein zweites simuliertes kaltes Extrudatprofil zu bestimmen, wobei die Vergleichseinheit ferner dazu ausgebildet ist, eine zweite Abweichung zwischen dem bestimmten zweiten simulierten kalten Extrudatprofil und dem spezifischen Extrudatprofil zu bestimmen.

3. Vorrichtung (10) nach einem der Ansprüche 1 oder 2,
**dadurch gekennzeichnet, dass**
die Vorrichtung eine Gewichtsbestimmungseinheit (110) zur Bestimmung eines warmen Extrudatgewichts des zumindest einen Extrudats (109, 209) aufweist, insbesondere an einer Ausgangsseite des Extrusionskopfs.

4. Vorrichtung (10) nach einem der vorhergehenden Ansprüche,
**dadurch gekennzeichnet, dass**
der Schwellwert einer Abweichung von weniger als 5%, weniger als 3%, weniger als 2%, weniger als 1% des zumindest ersten simulierten kalten Extrudatprofils und des spezifischen Extrudatprofils entspricht.

5. Vorrichtung (10) nach einem der vorhergehenden Ansprüche
**dadurch gekennzeichnet, dass**
die Profilbestimmungseinheit (111) dazu ausgebildet ist, ein zweites warmes Extrudatprofil für ein zweites warmes Extrudat (109, 209) zu bestimmen und mit dem simulierten warmen Extrudatprofil zu vergleichen, wobei die zweite Kaltprofil-Modellierungseinheit (408) dazu ausgebildet ist, das zweite warme Extrudatprofil zu verwenden, wenn eine Abweichung zwischen dem zweiten warmen Extrudatprofil und dem simulierten warmen Extrudatprofil größer als der Schwellwert ist, wobei insbesondere die Vergleichseinheit zur Bestimmung der Abweichung ausgebildet ist.

6. Vorrichtung (10) nach einem der vorhergehenden Ansprüche
**dadurch gekennzeichnet, dass**
die erste Kaltprofil-Modellierungseinheit (402), die zweite Kaltprofil-Modellierungseinheit (408) und/oder die Warmprofil-Modellierungseinheit als eine Modellierungseinheit ausgebildet sind.

7. Vorrichtung (10) nach einem der vorhergehenden Ansprüche
**dadurch gekennzeichnet, dass**
- das Extrudat (109, 209) in einem warmen Zustand eine Temperatur von mehr als 60°C, oder mehr als 55°C, oder mehr als 50°C aufweist und/oder auf einer Fördervorrichtung in einem Abstand von weniger als 40 m, oder weniger als 30 m, oder weniger als 20 m, oder kleiner gleich 10 m an der Ausgangsseite des Extrusionskopfs angeordnet ist und/oder
- das Extrudat (109, 209) in einem kalten Zustand eine Temperatur von kleiner gleich 50°C, oder weniger als 45°C, oder weniger als 40°C aufweist und/oder auf einer Fördervorrichtung in einem Abstand von mehr als 80 m, oder mehr als 50 m, oder mehr als 30 m, oder mehr als 10 m an der Ausgangsseite des Extrusionskopfs angeordnet ist.

8. Vorrichtung (10) nach einem der vorhergehenden Ansprüche
**dadurch gekennzeichnet, dass**
das Bestimmen des kalten Extrudatprofils und/oder das Bestimmen des warmen Extrudatprofils mittels künstlicher Intelligenz, insbesondere einem neuronalen Netz, weiter insbesondere einem LSTM-basierten System, und/oder Gradient Boostingdurchgeführt werden.

9. Vorrichtung (10) nach einem der vorhergehenden Ansprüche
**gekennzeichnet durch** einen Speicher, der dazu ausgebildet ist, warme und kalte Extrudatprofile von produzierten Extrudaten (109, 209) sowie Prozessparameter zu speichern, insbesondere in vordefinierten Intervallen, wobei die Kaltprofil- und/oder die Warmprofil-Modellierungseinheiten dazu ausgebildet sind, das Extrudatmodell unter Verwendung der gespeicherten Extrudatprofile zu trainieren.

10. Computerimplementiertes Verfahren zur Steuerung einer Extrusionsanlage (100, 200, 300), insbesondere mittels einer Vorrichtung (10) nach den Ansprüchen 1-9, folgende Schritte aufweisend:
a) Bestimmen eines warmen Extrudatprofils von mindestens einem Extrudat (109, 209) mittels einer Profilbestimmungseinheit, wobei das warme Extrudatprofil geometrische Daten des Extrudats (109, 209) in einem warmen Zustand angibt,
b) Parametrieren eines Extrudatmodells mittels einer ersten Kaltprofil-Modellierungseinheit (402) basierend auf dem warmen Extrudatprofil und initialen Prozessparametern, wobei das Extrudatmodell, ein erstes kaltes Extrudatprofil des Extrudats (109, 209) in einem abgekühlten Zustand bestimmt,
c) Bestimmen einer ersten Abweichung zwischen dem bestimmten ersten kalten Extrudatprofil und einem spezifischen Extrudatprofil mittels einer Vergleichseinheit,
d) Optimieren von Prozessparametern und Bestimmen von veränderten Prozessparametern unter Verwendung der ersten Abweichung mittels einer Parameterbestimmungseinheit, derart, dass eine Abweichung von einem produzierten kalten Extrudatprofil und dem spezifischen Extrudatprofil klein wird,
e) Auswählen der veränderten Prozessparameter als Eingabe für eine Ansteuerungseinheit der Extrusionsanlage, wenn die Abweichung kleiner gleich einem Schwellwert ist, mittels einer Auswahleinheit und
f) Steuern der Extrusionsanlage (100, 200, 300) mit den veränderten Prozessparametern mittels einer Ansteuerungseinheit.

11. Computerimplementiertes Verfahren nach Anspruch 10,
**dadurch gekennzeichnet, dass** das Optimieren der Prozessparameter umfasst:
- Bestimmen eines simulierten warmen Extrudatprofils basierend auf den veränderten Prozessparametern und dem warmen Extrudatprofil mittels einer Warmprofil-Modellierungseinheit (407), und
- Bestimmen eines zweiten simulierten Kaltprofils basierend auf dem simulierten warmen Extrudatprofil und veränderten Prozessparametern mittels einer zweiten Kaltprofil-Modellierungseinheit (408), wobei das Bestimmen ein Vergleichen des zweiten simulierten kalten Extrudatprofils mit dem spezifischen Extrudatprofil umfasst und das Bestimmen einer zweiten Abweichung zwischen dem zweiten simulierten kalten Extrudatprofil und dem spezifischen Extrudatprofil.

12. Computerimplementiertes Verfahren nach den Ansprüchen 10-11,
**dadurch gekennzeichnet, dass** das Optimieren der Prozessparameter umfasst:
- Bestimmen eines zweiten warmem Extrudatprofils für ein zweites warmes Extrudat (109, 209);
- Vergleichen des zweiten warmen Extrudaptofils mit dem dem simulierten warmen Extrudatprofil, insbesondere durch die Vergleichseinheit,
- Verwenden des zweiten warmen Extrudatprofil bei der Bestimmung des kalten Extrudatprofil, wenn eine Abweichung zwischen dem zweiten warmen Extrudatprofil und dem simulierten warmen Extrudatprofil größer als der Schwellwert ist.

13. Extrusionsanlage (100, 200, 300), insbesondere Multi-Extrusionsanlage, **gekennzeichnet durch**
- eine Vorrichtung (10) nach einem der Ansprüche 1-9;
- mindestens einen Extrusionskopf (107);
- mindestens eine Schnecke (105);
- mindestens einen Schneckenantrieb;
- mindestens einen Zylinder (104); und
- mindestens einen Befülltrichter; und/oder
- mindestens einer Materialtransporteinheit; und/oder
- mindestens einer Kühleinheit.

14. Computerlesbares Speichermedium, welches Instruktionen enthält, die Vorrichtung nach einem der Ansprüche 1 bis 10 zu veranlassen, die Schritte des Verfahrens nach einem der Ansprüche 10 bis 12 auszuführen.

## Claims

1. Apparatus (10) for controlling an extrusion installation (100, 200, 300) having at least one extrusion head (107) for shaping at least one extrudate (109), having the following:
- a profile determining unit which is configured to determine, in particular contactlessly, a warm extrudate profile of at least one extrudate (109, 209), wherein the warm extrudate profile defines geometric data of the extrudate (109, 209) in a warm state,
- a first cold-profile modelling unit (402) which is configured, on the basis of the warm extrudate profile and initial process parameters, to parameterize an extrudate model which determines a first cold extrudate profile of the extrudate (109, 209) in a cooled state,
- a comparison unit which is configured to determine a first deviation between the determined first cold extrudate profile and a specified extrudate profile,
- a parameter determining unit which is configured, using the first deviation, to optimize process parameters and to determine changed process parameters, such that a deviation of a cold extrudate profile that is produced from the specified extrudate profile becomes small,
- a selection unit which is configured to select the changed process parameters as the input for the activation unit if the deviation is less than or equal to a threshold value, and
- an actuating unit which is configured to control the extrusion installation (100, 200, 300) with the changed process parameters, in particular in order to produce a second warm extrudate (109, 209).

2. Apparatus (10) according to Claim 1,
**characterized in that**
the parameter determining unit has the following:
- a warm profile modelling unit which is configured to determine a simulated warm extrudate profile on the basis of the changed process parameters and/or the warm extrudate profile, and
- a second cold profile modelling unit (408) which is configured to determine a second simulated cold extrudate profile on the basis of the simulated warm extrudate profile and the changed process parameters, wherein the comparison unit is further configured to determine a second deviation between the determined second simulated cold extrudate profile and the specified extrudate profile.

3. Apparatus (10) according to either of Claims 1 and 2,
**characterized in that**
the apparatus has a weight determining unit (110) for determining a warm extrudate weight of the at least one extrudate (109, 209), in particular on an outlet side of the extrusion head.

4. Apparatus (10) according to one of the preceding claims,
**characterized in that**
the threshold value corresponds to a deviation of less than 5%, less than 3%, less than 2%, less than 1% of the at least first simulated cold extrudate profile from the specified extrudate profile.

5. Apparatus (10) according to one of the preceding claims,
**characterized in that**
the profile determining unit (111) is configured to determine a second warm extrudate profile for a second warm extrudate (109, 209) and to compare it with the simulated warm extrudate profile, wherein the second cold profile modelling unit (408) is configured to use the second warm extrudate profile if a deviation between the second warm extrudate profile and the simulated warm extrudate profile is greater than the threshold value, wherein in particular the comparison unit is configured to determine the deviation.

6. Apparatus (10) according to one of the preceding claims,
**characterized in that**
the first cold profile modelling unit (402), the second cold profile modelling unit (408) and/or the warm profile modelling unit are in the form of one modelling unit.

7. Apparatus (10) according to one of the preceding claims,
**characterized in that**
- the extrudate (109, 209) in a warm state has a temperature of more than 60°C, or more than 55°C, or more than 50°C and/or is arranged on a conveying apparatus at a distance of less than 40 m, or less than 30 m, or less than 20 m, or less than or equal to 10 m on the outlet side of the extrusion head, and/or
- the extrudate (109, 209) in a cold state has a temperature of less than or equal to 50°C, or less than 45°C, or less than 40°C and/or is arranged on a conveying apparatus at a distance of more than 80 m, or more than 50 m, or more than 30 m, or more than 10 m on the outlet side of the extrusion head.

8. Apparatus (10) according to one of the preceding claims,
**characterized in that**
the determination of the cold extrudate profile and/or the determination of the warm extrudate profile is carried out by means of artificial intelligence, in particular a neural network, more particularly an LSTM-based system, and/or gradient boosting.

9. Apparatus (10) according to one of the preceding claims,
**characterized by** a memory which is configured to store warm and cold extrudate profiles of extrudates (109, 209) that are produced as well as process parameters, in particular at predefined intervals, wherein the cold profile and/or the warm profile modelling units are configured to train the extrudate model using the stored extrudate profiles.

10. Computer-implemented method for controlling an extrusion installation (100, 200, 300), in particular by means of an apparatus (10) according to Claims 1-9, comprising the following steps:
a) determination of a warm extrudate profile of at least one extrudate (109, 209) by means of a profile determining unit, wherein the warm extrudate profile defines geometric data of the extrudate (109, 209) in a warm state,
b) parameterization of an extrudate model by means of a first cold profile modelling unit (402) on the basis of the warm extrudate profile and initial process parameters, wherein the extrudate model determines a first cold extrudate profile of the extrudate (109, 209) in a cooled state,
c) determination of a first deviation between the determined first cold extrudate profile and a specified extrudate profile by means of a comparison unit,
d) optimization of process parameters and determination of changed process parameters using the first deviation by means of a parameter determining unit, such that a deviation of a cold extrudate profile that is produced from the specified extrudate profile becomes small,
e) selection of the changed process parameters as the input for an actuating unit of the extrusion installation if the deviation is less than or equal to a threshold value, by means of a selecting unit, and
f) control of the extrusion installation (100, 200, 300) with the changed process parameters by means of an actuating unit.

11. Computer-implemented method according to Claim 10,
**characterized in that** the optimization of the process parameters comprises:
- determination of a simulated warm extrudate profile on the basis of the changed process parameters and the warm extrudate profile by means of a warm profile modelling unit (407), and
- determination of a second simulated cold profile on the basis of the simulated warm extrudate profile and changed process parameters by means of a second cold profile modelling unit (408), wherein the determination comprises a comparison of the second simulated cold extrudate profile with the specified extrudate profile and the determination of a second deviation between the second simulated cold extrudate profile and the specified extrudate profile.

12. Computer-implemented method according to Claims 10-11,
**characterized in that** the optimization of the process parameters comprises:
- determination of a second warm extrudate profile for a second warm extrudate (109, 209),
- comparison of the second warm extrudate profile with the simulated warm extrudate profile, in particular by the comparison unit,
- use of the second warm extrudate profile in the determination of the cold extrudate profile if a deviation between the second warm extrudate profile and the simulated warm extrudate profile is greater than the threshold value.

13. Extrusion plant (100, 200, 300), in particular multi-extrusion plant,
**characterized by**
- an apparatus (10) according to one of Claims 1-9;
- at least one extrusion head (107);
- at least one screw (105);
- at least one screw drive;
- at least one barrel (104); and
- at least one filling hopper; and/or
- at least one material transport unit; and/or
- at least one cooling unit.

14. Computer-readable storage medium which contains instructions which cause the apparatus according to one of Claims 1 to 10 to execute the steps of the method according to one of Claims 10 to 12.

## Revendications

1. Dispositif (10) de commande d'une installation d'extrusion (100, 200, 300) avec au moins une tête d'extrusion (107) destinée à façonner au moins un extrudat (109),
comportant les éléments suivants :
- une unité de détermination de profil, qui est réalisée pour déterminer, en particulier sans contact, un profil d'extrudat chaud d'au moins un extrudat (109, 209), le profil d'extrudat chaud indiquant des données géométriques de l'extrudat (109, 209) dans un état chaud,
- une première unité de modélisation de profil froid (402), qui est réalisée pour paramétrer, sur la base du profil d'extrudat chaud et de paramètres de processus initiaux, un modèle d'extrudat, qui détermine un premier profil d'extrudat froid de l'extrudat (109, 209) dans un état refroidi,
- une unité de comparaison, qui est réalisée pour déterminer un premier écart entre le premier profil d'extrudat froid déterminé et un profil d'extrudat spécifique,
- une unité de détermination de paramètres, qui est réalisée pour optimiser des paramètres de processus et pour déterminer des paramètres de processus modifiés en utilisant le premier écart de manière à réduire un écart d'un profil d'extrudat froid produit et du profil d'extrudat spécifique,
- une unité de sélection, qui est réalisée pour sélectionner les paramètres de processus modifiés en tant qu'entrée pour l'unité de pilotage lorsque l'écart est inférieur ou égal à une valeur de seuil, et
- une unité de pilotage, qui est réalisée pour commander l'installation d'extrusion (100, 200, 300) avec les paramètres de processus modifiés, en particulier pour produire un deuxième extrudat (109, 209) chaud.

2. Dispositif (10) selon la revendication 1,
**caractérisé en ce que**
l'unité de détermination de paramètres présente les éléments suivants :
- une unité de modélisation de profil chaud, qui est réalisée pour déterminer un profil d'extrudat chaud simulé sur la base des paramètres de processus modifiés et/ou du profil d'extrudat chaud, et
- une deuxième unité de modélisation de profil froid (408), qui est réalisée pour déterminer un deuxième profil d'extrudat froid simulé sur la base du profil d'extrudat chaud simulé et des paramètres de processus modifiés, l'unité de comparaison étant en outre réalisée pour déterminer un deuxième écart entre le deuxième profil d'extrudat froid simulé déterminé et le profil d'extrudat spécifique.

3. Dispositif (10) selon l'une des revendications 1 ou 2,
**caractérisé en ce que**
le dispositif comporte une unité de détermination de poids (110) destinée à déterminer un poids d'extrudat chaud de l'au moins un extrudat (109, 209), en particulier sur un côté de sortie de la tête d'extrusion.

4. Dispositif (10) selon l'une des revendications précédentes,
**caractérisé en ce que**
la valeur de seuil correspond à un écart inférieur à 5 %, inférieur à 3 %, inférieur à 2 %, inférieur à 1 % de l'au moins un premier profil d'extrudat froid simulé et du profil d'extrudat spécifique.

5. Dispositif (10) selon l'une des revendications précédentes,
**caractérisé en ce que**
l'unité de détermination de profil (111) est réalisée pour déterminer un deuxième profil d'extrudat chaud pour un deuxième extrudat chaud (109, 209) et le comparer au profil d'extrudat chaud simulé, la deuxième unité de modélisation de profil froid (408) étant réalisée pour utiliser le deuxième profil d'extrudat chaud lorsqu'un écart entre le deuxième profil d'extrudat chaud et le profil d'extrudat chaud simulé est supérieur à la valeur de seuil, l'unité de comparaison étant réalisée en particulier pour déterminer l'écart.

6. Dispositif (10) selon l'une des revendications précédentes,
**caractérisé en ce que**
la première unité de modélisation de profil froid (402), la deuxième unité de modélisation de profil chaud (408) et/ou l'unité de modélisation de profil chaud sont réalisées en tant qu'une unité de modélisation.

7. Dispositif (10) selon l'une des revendications précédentes,
**caractérisé en ce que**
- l'extrudat (109, 209) présente, dans un état chaud, une température supérieure à 60 °C ou supérieure à 55 °C ou supérieure à 50 °C et/ou est disposé, sur un dispositif de convoyage, à une distance inférieure à 40 m, ou inférieure à 30 m ou inférieure à 20 m ou inférieure ou égale à 10 m sur le côté de sortie de la tête d'extrusion, et/ou
- l'extrudat (109, 209) présente, dans un état froid, une température inférieure ou égale à 50 °C ou inférieure à 45 °C ou inférieure à 40 °C et/ou est disposé, sur un dispositif de convoyage, à une distance supérieure à 80 m, ou supérieure à 50 m ou supérieure à 30 m ou supérieure à 10 m sur le côté de sortie de la tête d'extrusion.

8. Dispositif (10) selon l'une des revendications précédentes,
**caractérisé en ce que**
la détermination du profil d'extrudat froid et/ou la détermination du profil d'extrudat chaud sont effectuées au moyen de l'intelligence artificielle, en particulier d'un réseau neuronal, par ailleurs en particulier d'un système basé sur une mémoire à court terme (LSTM) et/ou d'une potentialisation de gradient.

9. Dispositif (10) selon l'une des revendications précédentes,
**caractérisé par** une mémoire qui est réalisée pour stocker des profils d'extrudat chauds et froids d'extrudats (109, 209) produits ainsi que des paramètres de processus, en particulier à des intervalles prédéfinis, les unités de modélisation de profil froid et/ou de profil chaud étant réalisées pour entraîner le modèle d'extrudat en utilisant les profils d'extrudat stockés.

10. Procédé mis en œuvre par ordinateur pour commander une installation d'extrusion (100, 200, 300), en particulier au moyen d'un dispositif (10) selon les revendications 1-9, comportant les étapes suivantes :
a) détermination d'un profil d'extrudat chaud d'au moins un extrudat (109, 209) au moyen d'une unité de détermination de profil, le profil d'extrudat chaud indiquant des données géométriques de l'extrudat (109, 209) dans un état chaud,
b) paramétrage d'un modèle d'extrudat au moyen de la première unité de modélisation de profil froid (402) sur la base du profil d'extrudat chaud et de paramètres de processus initiaux, le modèle d'extrudat déterminant un premier profil d'extrudat froid de l'extrudat (109, 209) dans un état refroidi,
c) détermination d'un premier écart entre le premier profil d'extrudat froid déterminé et un profil d'extrudat spécifique au moyen d'une unité de comparaison,
d) optimisation de paramètres de processus et détermination de paramètres de processus modifiés en utilisant le premier écart au moyen de l'unité de détermination de paramètres de manière à réduire un écart d'un profil d'extrudat froid produit et du profil d'extrudat spécifique,
e) sélection des paramètres de processus modifiés en tant qu'entrée pour une unité de pilotage de l'installation d'extrusion lorsque l'écart est inférieur ou égal à une valeur de seuil, au moyen d'une unité de sélection, et
f) commande de l'installation d'extrusion (100, 200, 300) avec les paramètres de processus modifiés au moyen d'une unité de pilotage.

11. Procédé mis en œuvre par ordinateur selon la revendication 10,
**caractérisé en ce que** l'optimisation des paramètres de processus comprend :
- la détermination d'un profil d'extrudat chaud simulé sur la base des paramètres de processus modifiés et du profil d'extrudat chaud au moyen de l'unité de modélisation de profil chaud (407), et
- la détermination d'un deuxième profil froid simulé sur la base du profil d'extrudat chaud simulé et de paramètres de processus modifiés au moyen d'une deuxième unité de modélisation de profil froid (408), la détermination comprenant une comparaison du deuxième profil d'extrudat froid simulé au profil d'extrudat spécifique et la détermination d'un deuxième écart entre le deuxième profil d'extrudat froid simulé et le profil d'extrudat spécifique.

12. Procédé mis en œuvre par ordinateur selon les revendications 10-11,
**caractérisé en ce que** l'optimisation des paramètres de processus comprend :
- la détermination d'un deuxième profil d'extrudat chaud pour un deuxième extrudat (109, 209) chaud ;
- la comparaison du deuxième profil d'extrudat chaud au profil d'extrudat chaud simulé, en particulier par l'unité de comparaison,
- l'utilisation du deuxième profil d'extrudat chaud lors de la détermination du profil d'extrudat froid lorsqu'un écart entre le deuxième profil d'extrudat chaud et le profil d'extrudat chaud simulé est supérieur à la valeur de seuil.

13. Installation d'extrusion (100, 200, 300), en particulier installation d'extrusion multiple,
**caractérisée par**
- un dispositif (10) selon l'une des revendications 1-9 ;
- au moins une tête d'extrusion (107) ;
- au moins une vis sans fil (105) ;
- au moins un entraînement de vis sans fin ;
- au moins un cylindre (104) ; et
- au moins une trémie de remplissage ; et/ou
- au moins une unité de transport de matériau ; et/ou
- au moins une unité de refroidissement.

14. Support de stockage lisible par ordinateur, lequel contient des instructions pour amener le dispositif selon l'une des revendications 1 à 10 à exécuter les étapes du procédé selon l'une des revendications 10 à 12.
